Europäisches Patentamt

European Patent Office

Office européen des brevets

(11) Publication number: **0 399 241**
**A1**

(19)

## (12) EUROPEAN PATENT APPLICATION

(21) Application number: **90108001.0**

(22) Date of filing: **26.04.90**

(51) Int. Cl.5: **H01L 21/331, H01L 21/365,**
**H01L 29/73, H01L 29/267**

(30) Priority: **27.04.89 JP 108911/89**

(43) Date of publication of application:
**28.11.90 Bulletin 90/48**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Ito, Takashi, c/o Fujitsu Limited**

**Patent Department, 1015 Kamikodanaka,**
**Nakahara-ku**
**Kawasaki-shi, Kanagawa 211(JP)**
Inventor: **Sugii, Toshihiro, c/o Fujitsu Limited**
**Patent Department, 1015 Kamikodanaka,**
**Nakahara-ku**
**Kawasaki-shi, Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

(54) **Semiconductor device with a hetero bipolar transistor.**

(57) A method of manufacturing a semiconductor device comprising a silicon substrate structure (1; 12, 13) and a silicon carbide layer (6, 61) formed by a chemical vapour deposition method performed using reactant gas; comprising:-

forming a protection layer (5; 8; 9; 10) not reactive to the reactant gas, over the silicon substrate structure (1; 12, 13);

forming an aperture (51) for providing an active region (21) on the silicon substrate structure, the aperture passing through the protection layer (5; 8; 9; 10), so that the active region (21) is exposed in the aperture (51); and

forming the silicon carbide layer (6, 61) on the active region.

The silicon carbide layer may form an emitter of a hetero bipolar transistor.

FIG. 2

## Semiconductor device with a hetero bipolar transistor

The present invention relates to a method for manufacturing a semiconductor device, for example a method for manufacturing a semiconductor device with a hetero bipolar transistor (HBT) having a wide energy band gap emitter layer made of silicon carbide (SiC).

The bipolar transistor (BPT) is one of the basic elements of large-scale integrated circuits (LSIs), and the performance and properties of BPTs in LSIs, such as the operation speed and the packing density of BPTs, have been developed to a high degree by miniaturisation of BPT size and reduction of BPT parasitic resistance and capacitance. In the course of this development, it has been speculated that HBTs, having wide energy band gap emitters, might offer further improved performance. However, it has not been possible to provide a stable HBT on a silicon (Si) substrate.

The inventors of the present invention, together with others, carried out a study of the question of whether SiC might be useful for providing a wide energy band gap emitter for an HBT, and a wide energy band gap SiC emitter layer has been formed experimentally on an Si substrate. Results of this study were published by T. Sugii, T. Ito, Y. Furumura, M. Doki, F. Mieno and M. Maeda in 1987 under the title "Si Heterojunction Bipolar Transistors with Single-Crystalline $\beta$-SiC Emitter" in J. Electrochem. Soc., vol. 134, pp 2545-2549, in 1987.

The inventors have considered that in LSIs, HBTs should have a planar structure, the same as regular BPTs. However, they have found a problem to exist in the fabrication of a wide energy band gap SiC emitter layer. That is, when an SiC emitter layer is formed on a silicon dioxide (SiO$_2$) layer by a chemical vapour deposition (CVD) method in an atmosphere of a reactant gas consisting of methane (CH$_4$) and trichlorosilane (SiHCl$_3$), a part of the SiO$_2$ layer is deoxidized by CH$_4$, resulting in deterioration of insulation characteristics of the SiO$_2$ layer.

The SiC emitter layer is formed by the CVD method in accordance with the following chemical reaction:-
SiHCl$_3$ + CH$_4$ --> SiC + HCl (1000$^\circ$C),
wherein, HCl is hydrogen chloride and 1000$^\circ$C is the temperature at which the reaction is advanced.

Furthermore, the above reaction would usually be performed in a carrier gas of hydrogen (H$_2$), in order to avoid Si oxidisation.

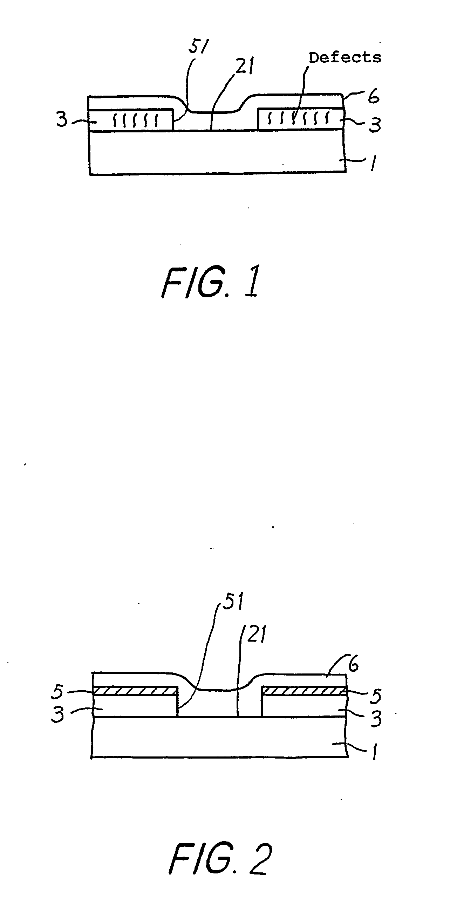

Fig. 1 is a cross-sectional view of an SiC layer 6 formed on an Si substrate 1 through an SiO$_2$ layer 3, and serves to illustrate the result of formation of an SiC layer 6 by a method as indicated above.

In Fig. 1, the SiO$_2$ layer 3 formed on the Si substrate 1 is partially etched to provide an active region 21 in an aperture 51. When the SiC layer 6 is grown on the active region 21, methane (CH$_4$) reacts with a part of the SiO$_2$ layer 3, so that parts are deoxidized, causing defects degrading the insulating characteristics of the SiO$_2$ layer 3. In particular, this reduction (of the oxide layer) occurs in an ambient gas H$_2$. Thus, considerable difficulties appear in relation to stable production of HBTs having planar structures with a wide energy band gap SiC emitter layer. Problems may also arise in the deposition of SiC on silicon.

The provision of a means or method by which such difficulties associated with the provision of an SiC layer can be overcome, particularly but not exclusively in relation to the manufacture of HBTs, is desired.

According to the present invention there is provided a method for manufacturing a semiconductor device comprising a silicon substrate and a silicon carbide layer formed by a chemical vapour deposition method performed by using a reactant gas; the method comprising:-
forming a protection layer not active on the reactant gas, on the silicon substrate;
forming an aperture for providing a reactive region on the silicon substrate, passing through said protection layer, so that said reactive region is exposed in said aperture; and
forming the silicon carbide layer on said reactive region.

The protection layer may be made of nitrided silicon oxide when the reactant gas consists of trichlorosilane and methane.

The step of forming the protection layer may be carried out by a chemical vapour deposition method performed in a gas consisting of ammonia and dichlorosilane.

The chemical vapour deposition method may be performed so that the protection layer has a thickness of 0.5 $\mu$m for example.

According to the present invention there is provided a method for manufacturing a semiconductor device comprising a silicon substrate, a silicon dioxide layer formed on the silicon substrate and a silicon carbide layer formed by a chemical vapour deposition method performed by using a reactant gas; the method comprising:-
forming a protection layer not active on the reactant gas, on the silicon dioxide layer;
forming an aperture for providing a reactive region on the silicon substrate, passing through said protection layer and the silicon dioxide layer, so that said reactive region is exposed in said aperture; and

forming the silicon carbide layer on said reactive region.

The protection layer may be formed by a sputtering method.

The sputtering method may be carried out so that the protection layer has a thickness of 0.1 μm, for example.

The protection layer may be made of a material selected from the group consisting of titanium nitride, nitride or silicide of zirconium or hafnium each belonging to the 4A group, nitride or silicide of vanadium, niobium or tantalum each belonging to the 5A group, nitride or silicide of chromium, molybdenum or tungsten each belonging to the 6A group, or nitride or silicide of cobalt, nickel or aluminium, when the reactant gas consists of trichlorosilane and methane.

The protection layer may be formed by a chemical vapour deposition method performed in a gas consisting of consisting of ammonia and dichlorosilane.

This chemical vapour deposition method may be carried out so that said protection layer has a thickness of 0.1 μm, for example.

The protection layer may be made of a material selected from the group consisting of silicon nitride or nitrided silicon oxide.

The protection layer may be of nitrided silicon oxide and may be formed by heating the silicon dioxide layer at approximately 1000°C in an atmosphere of ammonia for about 10 minutes.

An embodiment of the present invention can provide for stable production of HBTs having a wide energy band gap emitter made of SiC, with satisfactory or even excellent characteristics for the HBTs, such as high current gain and high operation speed.

In an embodiment of the present invention a method is provided of growing a wide energy band gap SiC emitter layer which has no adverse influence on an $SiO_2$ layer of an HBT. This method involves forming a protecting layer made of metal nitride or metal silicide, for instance, on the $SiO_2$ layer, for protecting the $SiO_2$ layer from deoxidisation by reactant gas used in the process by which the SiC layer is grown, before an activation region for growing the wide energy band gap SiC emitter layer is formed. Because of the formation of the protecting layer, insulation characteristics of the $SiO_2$ layer are free from degradation related to the reactant gas used during a CVD process by which the SiC layer is grown, which results in the possibility of stable production of HBTs having wide energy band gap emitter layers.

Embodiments of the present invention can be applied more generally in semiconductor device manufacture, when an SiC layer is required on a silicon substrate structure.

Reference is made, by way of example, to the accompanying drawings, in which:-

Fig. 1 is a schematic partially cross-sectional view serving to illustrate a bipolar transistor, having a SiC layer for forming a wide energy band gap emitter, fabricated by a previously proposed method,

Fig. 2 is a schematic partially cross-sectional view serving to illustrate a bipolar transistor having a protection layer between an $SiO_2$ layer and an SiC layer, fabricated by a method according to an embodiment of the present invention,

Figs. 3(a) to 3(h) are schematic partially cross-sectional views for illustrating steps involved in a first embodiment of the present invention,

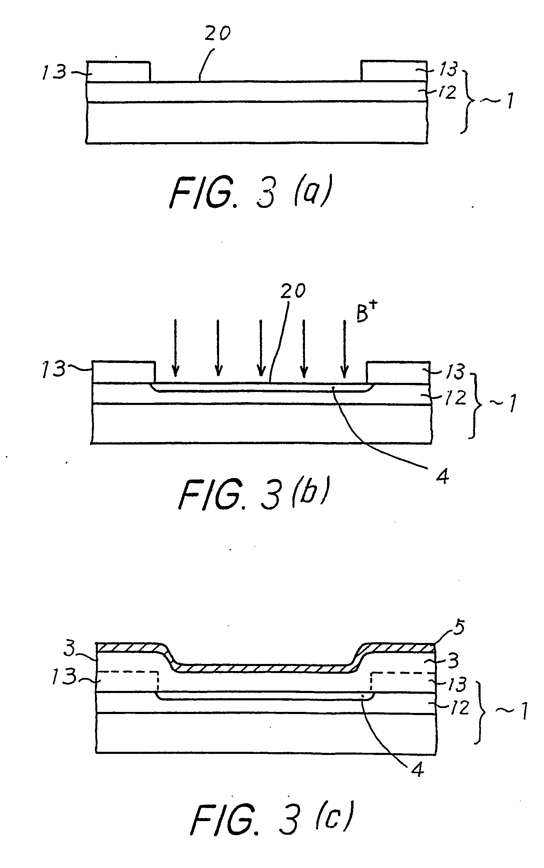

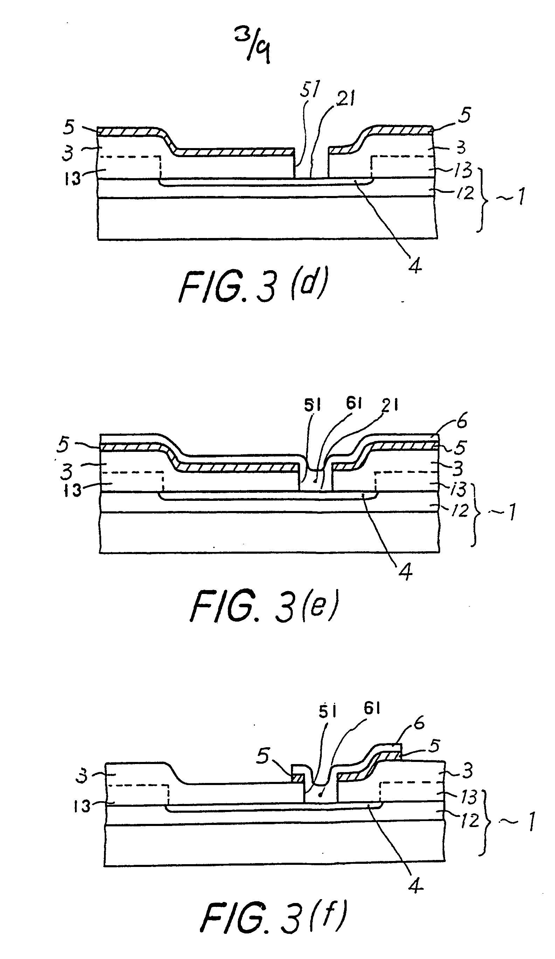

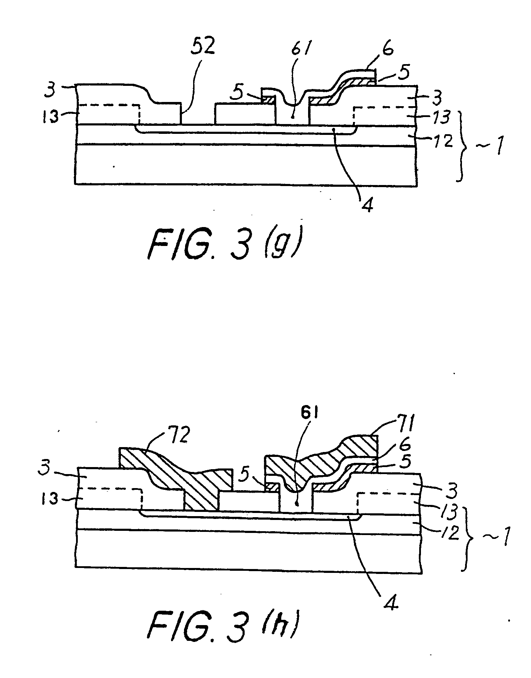

Fig. 3(a) illustrates a step for forming an aperture for providing a base region in an Si substrate including a first $SiO_2$ layer,

Fig. 3(b) illustrates a step for forming the base region,

Fig. 3(c) illustrates a step for forming a second $SiO_2$ layer on the base region and on the first $SiO_2$ layer and a step for forming a protection layer on the second $SiO_2$ layer,

Fig. 3(d) illustrates a step for forming an aperture for providing an active region on the base region, passing through the protection layer and the second $SiO_2$ layer,

·   Fig. 3(e) illustrates a step for forming an SiC layer on the active region and the protection layer,

Fig. 3(f) illustrates a step for removing the SiC layer and the protection layer, leaving them in and around the aperture filled with the SiC layer,

Fig. 3(g) illustrates a step for forming an aperture for forming a base electrode in the second silicon dioxide layer,

Fig. 3(h) illustrates a step for forming the base electrode and an emitter electrode,

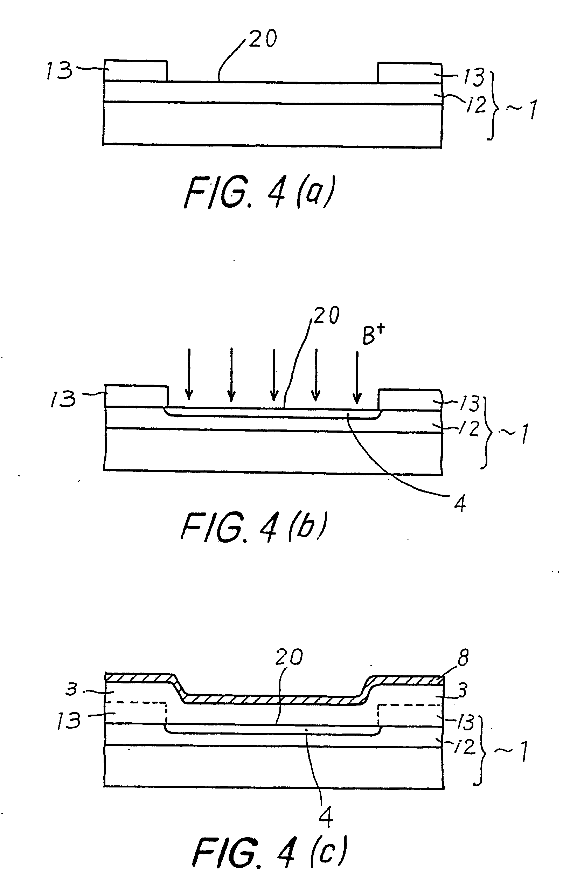

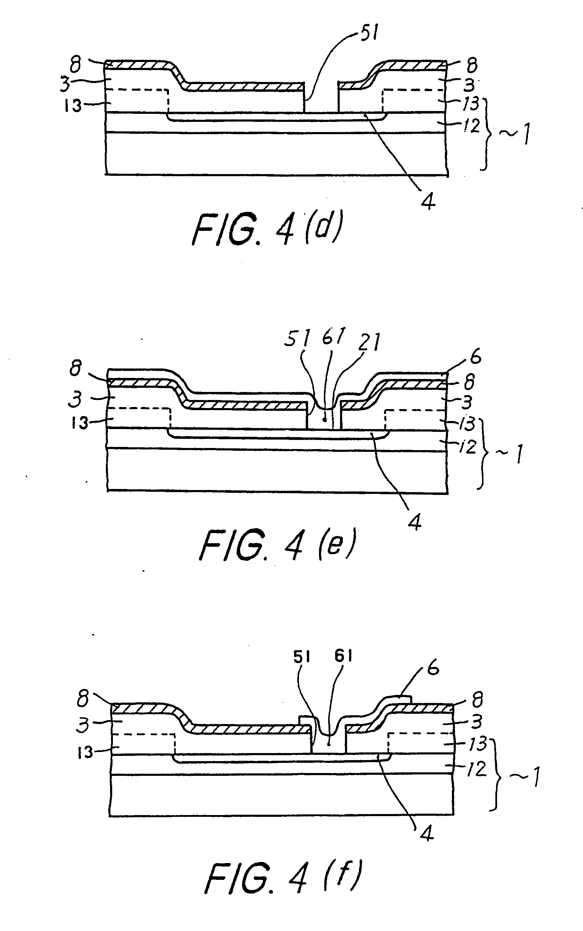

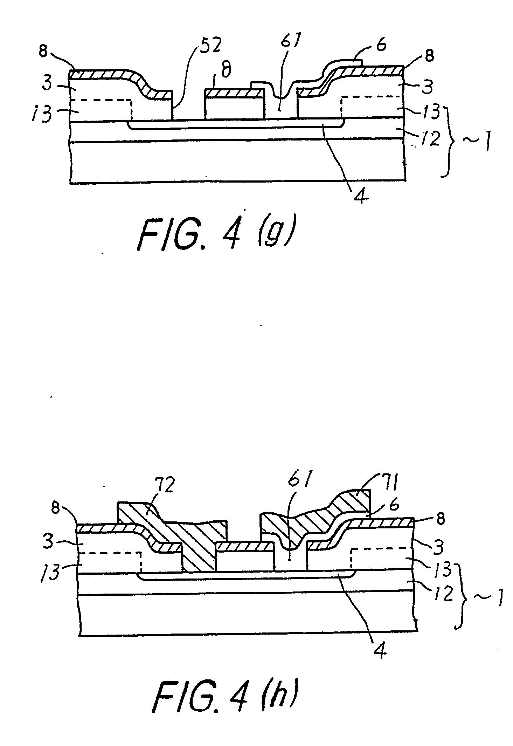

Fig. 4(a) to 4(h) are schematic partially cross-sectional views for illustrating steps involved in a second embodiment of the present invention,

Fig. 4(a) illustrates a step for forming an aperture for providing a base region in an Si substrate including a first $SiO_2$ layer,

Fig. 4(b) illustrates a step for forming the base region,

Fig. 4(c) illustrates a step for forming a second $SiO_2$ layer on the base region and the first $SiO_2$ layer and a step for forming a protection layer on the second $SiO_2$ layer,

Fig. 4(d) illustrates a step for forming an aperture for forming an active region on the base region, passing through the protection layer and the second $SiO_2$ layer,

Fig. 4(e) illustrates a step for forming an SiC layer on the active region and the protection layer,

Fig. 4(f) illustrates a step for removing the SiC layer, leaving the SiC layer in and around the aperture filled with the SiC layer,

Fig. 4(g) illustrates a step for forming an aperture for forming a base electrode in the second SiO₂ layer,

Fig. 4(h) illustrates a step for forming the base electrode and an emitter electrode;

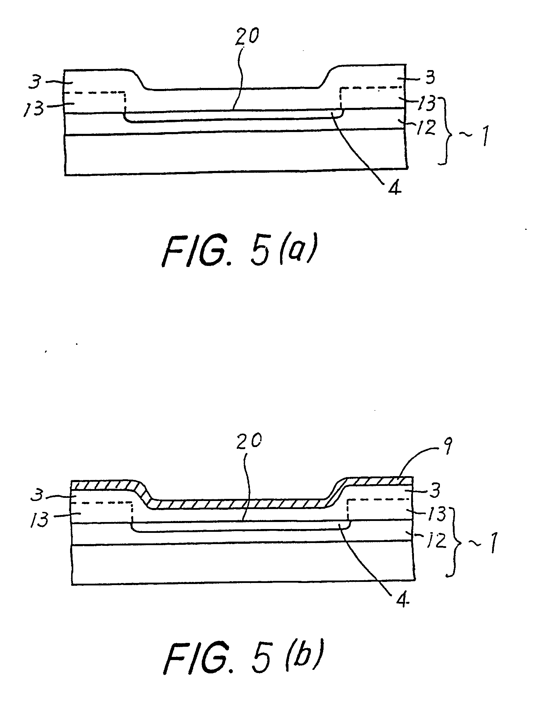

Figs. 5(a) and 5(b) are schematic partially cross-sectional views for illustrating steps involved in a third embodiment of the present invention,

Fig. 5(a) illustrates a step for forming a second SiO₂ layer on a base region and a first SiO₂ layer,

Fig. 5(b) illustrates a step for forming a protection layer for a depth of the second SiO₂ layer from an upper surface of the second SiO₂ layer; and

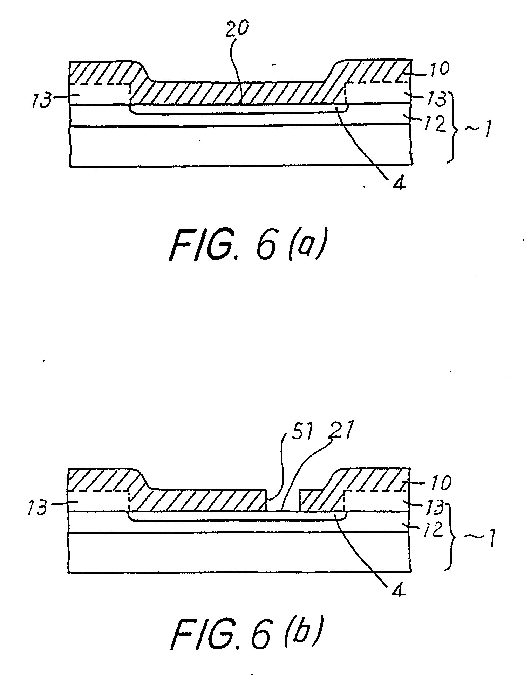

Figs. 6(a) and 6(b) are schematic partially cross-sectional views for illustrating steps involved in a fourth embodiment of the present invention,

Fig. 6(a) illustrates a step for forming a protection layer directly on a base region and a first SiO₂ layer, and

Fig. 6(b) illustrates a step for forming an aperture, in the protection layer, for providing an active region on the base region.

The partial cross-sectional view of an HBT in Fig. 2 serves for assistance in illustrating features of a semiconductor device, with an HBT, provided in accordance with an embodiment of the present invention. In Fig. 2, a protection layer 5 is formed on an SiO₂ layer 3 formed on an Si substrate 1 and an SiC layer 6 is grown on the protection layer 5 and an active (reactive) region 21 is formed by passing through the protection layer 5 and the SiO₂ layer 3. Since the protection layer 5 is formed on the SiO₂ layer 3, the SiO₂ layer 3 can be protected from being deoxidised due to reactant gas used in forming the SiC layer 6. Therefore, the insulation characteristics of the SiO₂ layer 3 can be protected from adverse effects of being deoxidised. Because of the provision of the protection layer 5 for an HBT, production of an LSI including an HBT having the wide energy band gap SiC emitter can be realised reliably.

A method of manufacturing a semiconductor device with an HBT having the wide energy band gap SiC emitter layer in accordance with a first embodiment of the present invention will be explained with reference to the partial cross-sectional views of Figs. 3(a) to 3(h). In Figs. 3(a) to 3(h), the same reference signs as in Fig. 2 designate the same or similar features (e.g. layer, substrate or aperture) as in Fig. 2.

In Fig. 3(a), an Si substrate 1, made of <111> oriented $n^+$-type Si, is first provided and an n-type Si layer 12, which is to be a collector region of an HBT, having 1 Ωcm resistivity is formed some depth into the Si substrate 1 from the upper surface thereof, and an SiO₂ layer 13 is formed to a depth of 1 μm into the n-type Si layer 12, from an upper surface thereof, by performing thermal oxidation of the Si substrate 1.

It is possible to provide a substrate structure in which an n-type layer (c.f. 12) and an SiO₂ layer (c.f. 13) are formed independently, so that they are not formed from the Si substrate. However, in this embodiment, the n-type Si layer 12 and the SiO₂ layer 13 are formed from the Si substrate 1 as mentioned above, so that it is considered that the n-type Si layer 12 and the SiO₂ layer 13 of the substrate structure are the parts of the Si substrate 1, as indicated by reference numeral 1 in Fig. 3(a).

After forming the SiO₂ layer 13, a region 20 for providing a base region 4, which is shown in Fig. 3-(b), is formed by etching the SiO₂ layer 13 so that an upper surface of the n-type silicon layer 12 is partially exposed in the region 20 as shown in Fig. 3(a).

As seen in Fig. 3(b), a p-type base region 4 is formed in the region 20 to a depth of 0.1 μm into the n-type Si layer 12 from the upper surface thereof, by ion (boron $B^+$) implantation performed so that the concentration of $B^+$ in the base region 4 is as high as $10^{17} cm^{-3}$.

As seen in Fig. 3(c), an SiO₂ layer 3 is formed on all upper surfaces of the SiO₂ layer 13 and the base region 4 by a CVD method, and a protection layer 5 made of titanium nitride is formed on the SiO₂ layer 3, to a thickness of as much as 0.1 μm, by a spattering (sputtering) method.

As indicated by Fig. 3(d), a resist pattern (not depicted) having a resist aperture is used for forming a wide energy band gap emitter of an HBT. The resist pattern is formed on the protection layer 5 so that the resist aperture is positioned above the base region 4, and an aperture 51 for providing an active region 21, to have a wide energy band gap emitter thereon, is formed, passing through the protection layer 5 and the SiO₂ layer 3, by etching using the resist pattern.

In Fig. 3(e), an SiC layer 6 is deposited on the active region 21 in the aperture 51, and on the protection layer 6, through epitaxial growth using a CVD method performed with a reactant gas consisting of trichlorosilane (SiHCl₃) and methane (CH₄). The SiC layer 6 deposited in and around the aperture 51 is partially formed to be an n-type SiC layer by doping (with phosphor or phosphorus) for providing a wide energy band gap emitter region 61, and the rest of the SiC layer 6 deposited on the protection layer is formed as polycrystalline SiC.

As indicated in Fig. 3(f), the SiC layer 6 formed on the protection layer 5 is removed by patterning, leaving the SiC layer 6 at and around the emitter region 61, and the protection layer 5 is removed by self-aligned etching performed by using the remaining SiC layer 6, leaving the protection layer 5 laid beneath the remaining SiC layer 6.

As seen in Fig. 3(g), another aperture 52 for providing a base electrode of an HBT is formed, passing through the layer 3 so that the aperture 52 is positioned on the base region 4, spaced apart from the emitter region 61.

As seen in Fig. 3(h), aluminium (Al) is evaporated on to all of the upper surfaces of the structure of Fig. 3(g), and an emitter electrode 71 and a base electrode 72 are formed by patterning the evaporated Al.

In accordance with the first embodiment, the protection layer 5 is made of titanium nitride not reactive on the reactant gas used in forming the SiC layer 6, so that the $SiO_2$ layers 3 and 13 can be well protected from being deoxidised by the reactant gas.

Generally, in a bipolar transistor, base resistance is reduced by increasing impurity concentration of the base, to obtain higher operation speed. However, when the impurity concentration is increased, current gain of the bipolar transistor is usually decreased. In contrast, in an HBT formed in accordance with the first embodiment, current gain does not decrease even if $B^+$ concentration of the base region 4 is increased as high as $10^{19} cm^{-3}$.

Furthermore, an HBT fabricated in accordance with the first embodiment has an excellent junction characteristic between the base region 4 and the emitter region 61. This is evident from the fact that an "n" value of the HBT is 1.05, i.e. near to 1. This "n" value is a current-voltage characteristic representing the junction quality of the bipolar transistor such that the more nearly the "n" value approaches 1, the higher the junction quality. From this, it can be concluded that the first embodiment provides for stable production of an HBT having a high-quality SiC/Si heterojunction.

In the first embodiment, titanium nitride is used for the protection layer 5. However, as alternatives, either a nitride or silicide of a group 4A element, such as zirconium (Zr) or hafnium (Hf), a group 5A element, such as vanadium (V), niobium (Nb) or tantalum (Ta), or a group 6A element, such as chromium (Cr), molybdenum (Mo) or tungsten (W), can be used, and either a nitride or silicide of an element such as cobalt (Co), nickel (Ni) or aluminium (Al) can also be used for the protection layer 5.

A second embodiment of the present invention will be explained with reference to the partial cross-sectional views of Figs. 4(a) to 4(h). In Figs. 4(a) to 4(h), the same reference signs as in Figs. 3(a) to 3-(h) designate the same or similar features (e.g. layer, substrate or aperture) as in Figs. 3(a) to 3(h).

In Figs. 4(a) and 4(b), the same fabricating processes as described in relation to Figs. 3(a) and 3(b) are performed respectively.

As seen in Fig. 4(c), an $SiO_2$ layer 3 is formed on an upper surface of the structure shown in Fig. 4(b), by a CVD method, to as much as 0.5 μm thickness, and a protection layer 8 of silicon nitride ($Si_3N_4$) is formed on the $SiO_2$ layer 3, to as much as 0.1 μm thickness, by a CVD method performed in a gas consisting of ammonia ($NH_3$) and dichlorosilane ($SiCl_2H_2$).

As indicated by Fig. 4(d), a resist pattern, not depicted in Fig. 4(d), having a resist aperture for use in forming a wide energy band gap emitter of an HBT, is formed on the protection layer 8 so that the resist aperture is positioned above the base region 4. An aperture 51 for providing an active region 21 for forming the wide energy band gap emitter thereon is formed, passing through the protection layer 5 and the $SiO_2$ layer 3, by etching by using the resist pattern.

As seen in Fig. 4(e), an SiC layer 6 is deposited on the active region 21 in the aperture 51 in accordance with epitaxial growth carried out by a CVD method performed with a reactant gas consisting of trichlorosilane ($SiHCl_3$) and methane ($CH_4$). The SiC layer 6 deposited in and around the aperture 51 is partially formed as an n-type SiC layer by doping (with phosphor or phosphorus) for providing a wide energy gap emitter region 61, and the rest of the SiC layer 6 deposited on the protection layer 5 is formed as polycrystalline SiC.

As indicated in Fig. 4(f), parts of the SiC layer 6 are removed by patterning, leaving the SiC layer 6 at and around the emitter region 61.

As seen in Fig. 4(g), another aperture 52 is formed, for providing a base electrode of an HBT, passing through the protection layer 8 and the SiC layer 3 so that the aperture 52 is positioned on the base region 4 spaced apart from the emitter region 61.

As seen in Fig. 4(h), aluminium (Al) is evaporated on all the upper surface of the structure of Fig. 4(g), and an emitter electrode 71 and a base electrode 72 are formed by patterning the evaporated Al.

As for the first embodiment, an HBT provided in accordance with the second embodiment does not suffer decreased current gain even if the $B^+$ concentration of the base region 4 is increased as high as $10^{19} cm^{-3}$, and the HBT has an excellent junction characteristic between the base region 4 and the emitter region 61. The "n" value is 1.05, the same as is provided in relation to the first embodiment, so that an excellent SiC/Si heterojunction can be formed also in relation to the second embodiment.

In relation to the second embodiment, the protection layer 8 is made of $Si_3N_4$. However, a nitrid-

ed silicon oxide can be used instead of Si$_3$N$_4$. The formation of a nitrided silicon oxide layer will be explained in relation to a third embodiment of the present invention, with reference to Figs. 5(a) and 5(b). In Figs. 5(a) and 5(b), the same reference signs as in Fig. 4(c) designate the same or similar items as in Fig. 4(c).

In Fig. 5(a), the SiO$_2$ layer 3 is formed to a thickness of as much as 0.5 µm in the same way as explained in relation to the second embodiment with reference to Fig. 4(c), and in Fig. 5(b), a nitrided silicon oxide layer 9 is formed to a depth of 10 nm in the SiO$_2$ layer 3 from the upper surface thereof by heating the structure shown in Fig. 5(a) at approximately 1000°C in an atmosphere of ammonia (NH$_3$) for about 10 minutes.

In the case of the third embodiment, the same steps as those explained in relation to the second embodiment performed with reference to Figs. 4(a) to 4(b) and Figs. 4(d) to 4(h) are carried out before and after the steps explained with reference to Figs. 5(a) and 5(b), respectively.

Another method for forming a protection layer will be explained in relation to a fourth embodiment of the present invention with reference to Figs. 6(a) and 6(b). In Figs. 6(a) and 6(b), the same reference signs as in Figs. 4(c) and 4(d) designates the same items (e.g. layer, substrate, or aperture) as in Figs. 4(c) and 4(d). In the fourth embodiment, a nitrided silicon oxide layer 10 is directly formed on the active region 20 and the SiO$_2$ layer 13 without forming an SiO$_2$ layer such as is provided by the SiO$_2$ layer 3 in the second embodiment.

In Fig. 6(a), the protection layer 10 is formed to a thickness of as much as 0.5 um by a CVD method, using ammonia (NH$_3$) and dichlorosilane (SiCl$_2$H$_2$), as in the step explained with reference to Fig. 4(c) in relation to the second embodiment.

In Fig. 6(b), in the same way as in the step explained in relation to the second embodiment with reference to Fig. 4(d), the aperture 51 for the wide energy band gap emitter is formed, in this case passing through the protection layer 10, by etching.

In the case of the fourth embodiment, the same steps as those explained in relation to the second embodiment performed with reference to Figs. 4(a) to 4(b) and Figs. 4(e) to 4(h) are carried out respectively before and after the steps explained with reference to Figs. 6(a) and 6(b) for the fourth embodiment.

In accordance with an embodiment of the present invention a protection layer for protecting a silicon dioxide layer formed on a silicon substrate of a semiconductor device is formed on the silicon dioxide layer. The protection layer protects the silicon dioxide layer from reaction with a reactant gas used in a chemical vapour deposition method performed for forming a silicon carbide layer. The silicon carbide layer is used to provide a wide energy band gap emitter layer of the semiconductor device (and is formed on or over the silicon dioxide layer). The silicon carbide layer is formed on an active region formed on the silicon substrate in an aperture provided by etching the protection layer and the silicon dioxide layer. The protection layer is made of material being not reactive to the reactant gas, for example consisting of trichlorosilane and methane, and is for instance titanium nitride formed by a sputtering method, silicon nitride formed by a chemical vapour deposition method or nitrided silicon oxide formed by heating the silicon dioxide layer.

## Claims

1. A method of manufacturing a semiconductor device comprising a silicon substrate structure (1; 12, 13) and a silicon carbide layer (6, 61) formed by a chemical vapour deposition method performed using reactant gas; said method comprising:-

forming a protection layer (5; 8; 9; 10) not reactive to the reactant gas, over the silicon substrate structure (1; 12, 13);

forming an aperture (51) for providing an active region (21) on the silicon substrate structure, the aperture passing through the protection layer (5; 8; 9; 10), so that the active region (21) is exposed in the aperture (51); and

forming the silicon carbide layer (6, 61) on the active region.

2. A method as claimed in claim 1, wherein the protection layer (10) is formed of nitrided silicon oxide when the reactant gas consists of trichlorosilane and methane.

3. A method as claimed in claim 2, wherein the protection layer (10) is formed by a chemical vapour deposition method performed in a gas consisting of ammonia and dichlorosilane.

4. A method as claimed in claim 3, wherein said chemical vapour deposition method is performed so that the protection layer (10) has a thickness of 0.5 µm.

5. A method as claimed in claim 2, 3 or 4, wherein the silicon substrate structure comprises a silicon dioxide layer (13), which may be patterned, over which the protection layer is formed.

6. A method as claimed in claim 1, wherein a silicon dioxide layer (3) is formed over the silicon substrate structure (1; 12, 13), which structure may itself comprise another silicon dioxide layer (13) which may be patterned, the protection layer (5; 8; 9) is formed on or of the so-formed silicon dioxide layer (3), and the aperture (51) also passes through the so-formed silicon dioxide layer (3).

7. a method as claimed in claim 6, wherein protection layer (5) is formed by a sputtering method.

8. A method as claimed in claim 7, wherein the sputtering method is carried out so that the protection layer (5) has a thickness of 0.1 $\mu$m.

9. A method as claimed in claim 6, 7 or 8, wherein the protection layer (5) is made of a material selected from the group consisting of:- titanium nitride, nitride or silicide of zirconium or hafnium, each belonging to group 4A, nitride or silicide of vanadium, niobium or tantalum, each belonging to group 5A, nitride or silicide of chromium, molybdenum or tungsten, each belonging to group 6A, and nitride or silicide of cobalt, nickel or aluminium, when the reactant gas consists of trichlorosilane and methane.

10. A method as claimed in claim 6, wherein the protection layer (8) is formed by a chemical vapour deposition method performed in a gas consisting of ammonia and dichlorosilane.

11. A method as claimed in claim 10, wherein the chemical vapour deposition method is carried out so that the protection layer (8) has a thickness of 0.1 $\mu$m.

12. A method as claimed in claim 10 or 11, wherein the protection layer (8) is made of silicon nitride.

13. A method as claimed in claim 10 or 11, wherein the protection layer (8) is made of nitrided silicon oxide.

14. A method according to claim 6, wherein the protection layer (9) is made of nitrided silicon oxide and the protection layer (9) is formed by heating the silicon dioxide layer (3) formed over the silicon substrate structure, at approximately 1000°C in an atmosphere of ammonia for about 10 minutes.

15. A method as claimed in any preceding claim, wherein the semiconductor device comprises a hetero bipolar transistor, of which the silicon carbide layer (6, 61) provides a wide energy band gap emitter layer.

16. A method as claimed in claim 15, read as appended to any one of claims 5 to 14, wherein the silicon substrate structure comprises a patterned silicon dioxide layer (13) and a base region (4) for the hetero bipolar transistor, formed through a pattern opening in the patterned silicon dioxide layer (13), wherein the protection layer (5; 8; 9; 10) is formed over the patterned silicon dioxide layer (13) and the base region (4), and wherein the aperture (51) with the silicon carbide layer (6, 61) therein is formed over the base region (4) for providing the wide energy band gap emitter layer.

17. A method as claimed in claim 16, wherein a further aperture (52) is provided, in which the base region (4) is exposed, for a base electrode.

*FIG. 1*

*FIG. 2*

FIG. 3 (a)

FIG. 3 (b)

FIG. 3 (c)

3/9

FIG. 3 (d)

FIG. 3(e)

FIG. 3(f)

FIG. 3 (g)

FIG. 3 (h)

FIG. 4 (a)

FIG. 4 (b)

FIG. 4 (c)

FIG. 4 (d)

FIG. 4 (e)

FIG. 4 (f)

FIG. 4 (g)

FIG. 4 (h)

*FIG. 5 (a)*

*FIG. 5 (b)*

FIG. 6 (a)

FIG. 6 (b)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | JOURNAL OF THE ELECTROCHEMICAL SOCIETY, vol. 135, no. 5, May 1988, pages 1255-1260, Manchester, NH, US; Y. FURUMURA et al.: "Heteroepitaxial beta-SiC on Si" * Figure 3 * | 1 | H 01 L 21/331<br>H 01 L 21/365<br>H 01 L 29/73<br>H 01 L 29/267 |
| A | IDEM | 2,3,5 | |
| X | PATENT ABSTRACTS OF JAPAN, vol. 12, no. 77 (E-589)[2924], 10th March 1988; & JP-A-62 216 364 (FUJITSU LTD) 22-09-1987 * Abstract; figure * | 1,15 | |
| A | IDEM | 6 | |
| D,A | JOURNAL OF THE ELECTROCHEMICAL SOCIETY: SOLID STATE SCIENCE AND TECHNOLOGY, vol. 134, no. 10, October 1987, pages 2545-2549; Y. FURUMURA et al.: "Si heterojunction bipolar transistors with single-crystalline beta-SiC emitters" * Figure 5 * | 1,15 | TECHNICAL FIELDS SEARCHED (Int. Cl.5)<br><br>H 01 L |
| A | IEEE ELECTRON DEVICE LETTERS, vol. EDL-9, no. 2, February 1988, pages 87-89, IEEE, New York, US; T. SUGII et al.: "Beta-SiC/Si heterojunction bipolar transistors with high current gain" * Figure 1 * | 1,15 | |

The present search report has been drawn up for all claims

| Place of search | Date of completion of the search | Examiner |
|---|---|---|
| THE HAGUE | 24-08-1990 | GELEBART J.F.M. |